# EUROPÄISCHE PATENTSCHRIFT

(11) **EP 0 668 995 B1**
(45) Veröffentlichungstag und Bekanntmachung des Hinweises auf die Patenterteilung: **21.01.1998**
(21) Anmeldenummer: 94900079.8
(22) Anmeldetag: 27.10.1993
(51) Int. Cl.: G01L 9/00, G03F 1/14, G01D 5/02, F04B 43/02, F16K 7/12

(54) **VERFAHREN ZUR HERSTELLUNG MINDESTENS EINER DURCH EINEN RAHMEN AUFGESPANNTEN MEMBRAN**
METHOD OF FABRICATING AT LEAST A MEMBRANE MOUNTED ON A FRAME
PROCEDE DE FABRICATION AU MOINS UNE MEMBRANE MONTEE SUR UN CADRE

(30) Priorität: 16.11.1992 DE 4238571
(43) Veröffentlichungstag der Anmeldung: 30.08.1995
(73) Patentinhaber: Forschungszentrum Karlsruhe GmbH, 76133 Karlsruhe (DE); MICROPARTS GESELLSCHAFT FÜR MIKROSTRUKTURTECHNIK mbH, D-44227 Dortmund (DE)
(72) Erfinder: SCHOMBURG, Werner, D-76229 Karlsruhe (DE); RAPP, Richard, D-76297 Stutensee (DE); KADEL, Klaus, D-76185 Karlsruhe (DE)
(74) Vertreter: Rückert, Friedrich, Dr.
(86) Internationale Anmeldenummer: EP9302969
(87) Internationale Veröffentlichungsnummer: WO9411719

(56) Entgegenhaltungen:
- EP-A- 0 381 046
- EP-A- 0 474 280
- DE-A- 3 802 545
- DE-A- 3 920 788

## Beschreibung

Die Erfindung betrifft ein Verfahren zur Herstellung mindestens einer durch einen Rahmen aufgespannten Membran. Gemäß diesem Verfahren sind Membranpumpen und Membranventile erhältlich.

Ein solches Verfahren ist sowohl aus der DE 39 20 788 C1 als auch aus der Veröffentlichung "Mikromembranen für berührungslose Messungen mit Ultraschall" von W. K. Schomburg, M. Walter, R. Köhler und V. Liebig, VDI-Berichte Nr. 939 (1992) 543-548 bekannt. In der Veröffentlichung wird über die Herstellung wabenförmiger, über einem Rahmen frei gespannter, 3 µm dünner Mikromembranen aus Titan mit lateralen Abmessungen von ca. 80 µm berichtet. Diese Mikromembranen wiesen eine Resonanzfrequenz von 3 MHz auf. Die Resonanzfrequenz ist unter anderem von der Temperatur, der Dehnung und dem Differenzdruck über der Membran abhängig, so daß sich damit diese Parameter bestimmen lassen. Die durch den Rahmen aufgespannten Mikromembranen werden in der folgenden Weise hergestellt:

Auf einer Siliciumscheibe als Substrat wird eine Membranschicht so aufgetragen, daß sie sich vom Substrat wieder trennen läßt. Hierzu wird die Siliciumscheibe zuvor mit einer ca. 100 nm dünnen Trennschicht aus Kohlenstoff versehen, wobei ein ca. 3 mm breiter Rand der Siliciumscheibe nicht mitbeschichtet wird. Hierauf wird die Membranschicht aus Titan durch Magnetronzerstäubung 3 µm dick aufgetragen, so daß sie nur am Rand auf der Siliciumscheibe haftet. Auf der Membranschicht wird durch die bekannten Verfahren der Röntgentiefenlithographie mit anschließender galvanischer Abformung eine mehrere 10 µm dicke, wabenförmige Nickelstruktur aufgebaut. Um die Nickelstruktur herum wird ein fester, höherer Rahmen auf die Membranschicht aufgeklebt und die Membranschicht entlang des Randes von der Siliciumscheibe entfernt. Danach besteht zwischen der Membranschicht und der Siliciumscheibe keine feste Verbindung mehr, so daß die Siliciumscheibe in einer speziellen Einrichtung bei leichter Biegebeanspruchung von der Membranschicht getrennt werden kann. Auf diese Weise erhält man eine durch den Rahmen aufgespannte Membran, die durch die Nickelstruktur in Mikromembranen eingeteilt ist.

Beim bekannten Verfahren ergeben sich Membranen mit einheitlichen Eigenschaften. Die Auslenkung der Membranen ist unter anderem von den Membranabmessungen, der Membrandicke der inneren mechanischen Spannung und dem Elastizitätsmodul der Membran bestimmt. Für bestimmte Anwendungen, z. B. für die Herstellung von Mikromembranpumpen oder Mikromembranventilen, sind durch einen Rahmen aufgespannte Membranen mit lokal unterschiedlichen Eigenschaften vorteilhafter. So kann es beispielsweise für eine Mikromembranpumpe von Vorteil sein, wenn die Membran im Bereich der Pumpenkammer dehnbarer ist als im Bereich der Zuleitungen und Ventile. Außerdem kann für das Herstellungsverfahren einer Membranpumpe eine bestimmte Materialeigenschaft wie z. B. elektrische Leitfähigkeit wichtig sein, während im Bereich der Ventile oder der Pumpenmembran andere Eigenschaften wie z. B. die Dehnbarkeit im Vordergrund stehen und daß sich diese Eigenschaften nicht am selben Ort gleichzeitig optimieren lassen.

Der Erfindung liegt daher die Aufgabe zugrunde, ein Verfahren der eingangs genannten Art vorzuschlagen, mit dem durch einen Rahmen aufgespannte Membranen (oder eine Membran) hergestellt werden können, die an einzelnen, vorherbestimmbaren Stellen andere physikalische Eigenschaften aufweisen als an den übrigen Stellen.

Diese Aufgabe wird erfindungsgemäß durch den Patentanspruch 1 gelöst. Die Unteransprüche geben vorteilhafte Ausgestaltungen der Erfindung wieder.

Erfindungswesentlich ist, daß an der Stelle oder den Stellen, an denen die Membran andere physikalische Eigenschaften aufweisen soll, die erste auf das Substrat aufgetragene Membranschicht mit mindestens einem Durchbruch versehen wird. Die Lage und die Größe dieses Durchbruchs bestimmt die Stelle, an der die fertiggestellte Membran zumindest eine gegenüber dem Rest der Membran unterschiedliche physikalische Eigenschaft wie z. B. Dehnfähigkeit oder Schwingungsverhalten aufweist.

Der Durchbruch in der ersten Membranschicht wird durch eine zweite Membranschicht abgedeckt, wobei meist die zweite Membranschicht die erste Membranschicht überlappt. Der überlappende Bereich richtet sich nach der Art der Membranschichten und nach den gewünschen Eigenschaften der Gesamtmembran, die aus der ersten und der zweiten Membranschicht besteht. Der überlappende Bereich kann auf den Rand des Durchbruchs beschränkt sein oder den gesamten Bereich der ersten Membranschicht einschließen.

Die Strukturierung der Membranschichten kann in bekannter Weise durch optische Lithographieverfahren mit anschließendem naßchemischen Ätzen erfolgen.

Vorzugsweise wird das Substrat vor dem Auftragen der ersten Membranschicht mit einer Trennschicht versehen. Die Trennschicht wird so gewählt, daß das Anhaften sowohl der ersten als auch der zweiten Membranschicht auf dem Substrat verhindert wird. In den meisten Fällen sind Trennschichten aus Kohlenstoff und/oder Gold für diesen Zweck geeignet. Kohlenstoff ist insbesondere geeignet, wenn sowohl die erste als auch die zweite Membranschicht aus einem Metall bestehen. Gold wird dann eingesetzt, wenn z. B. die zweite Membranschicht aus einem Kunststoff besteht.

Prinzipiell brauchen die erste und die zweite Membranschicht nicht aus unterschiedlichen Materialien bestehen. Zur Erzielung von lokal unterschiedlichen Eigenschaften reicht es aus, wenn die Gesamtmembran an den Stellen, an denen die Durchbrüche hergestellt werden, eine andere Dicke oder eine andere innere Spannung aufweist. An diesen Stellen liegt dann z. B. ein anderes Dehn- oder Schwingungsverhalten vor.

In vielen Fällen ist es jedoch vorteilhafter, wenn für die erste und die zweite Membranschicht unterschiedliche Materialien verwendet werden, denn damit ändern sich die physikalischen Eigenschaften im Bereich der Durchbrüche in wesentlich stärkerem Maß.

In einer bevorzugten Ausführungsform besteht die erste Membranschicht aus einem Metall, z. B. Titan, und die zweite Membranschicht aus einem Kunststoff. Vorzugsweise wird in diesem Fall als Kunststoff ein solches Polymer oder Copolymer gewählt, das durch Lithographieverfahren (Bestrahlen mit Licht/Röntgenlicht und anschließendes Herauslösen entweder der bestrahlten oder der unbestrahlten Bereiche) strukturiert werden kann. Ein hierfür besonders geeigneter Kunststoff ist Polyimid. Durch die Herstellung einer Gesamtmembran, die aus einer ersten Membranschicht aus einem Metall wie Titan und aus einer zweiten Membranschicht aus Polyimid besteht, werden lokal besonders stark differierende physikalische Eigenschaften erzielt.

Werden Gesamtmembranen mit bereichsweise unterschiedlichem Schwingungsverhalten gewünscht, kann sowohl die erste als auch die zweite Membranschicht aus einem Metall bestehen. Eine bevorzugte Kombination ist beispielsweise Titan/Wolfram.

Der Rahmen über der Gesamtmembran kann mit einer Deckplatte versehen werden. Die hierdurch erhaltenen Gegenstände eignen sich insbesondere als Mikromembranpumpen oder Mikromembranventile. Die Medienzuführungen lassen sich hierbei in den Rahmen integrieren.

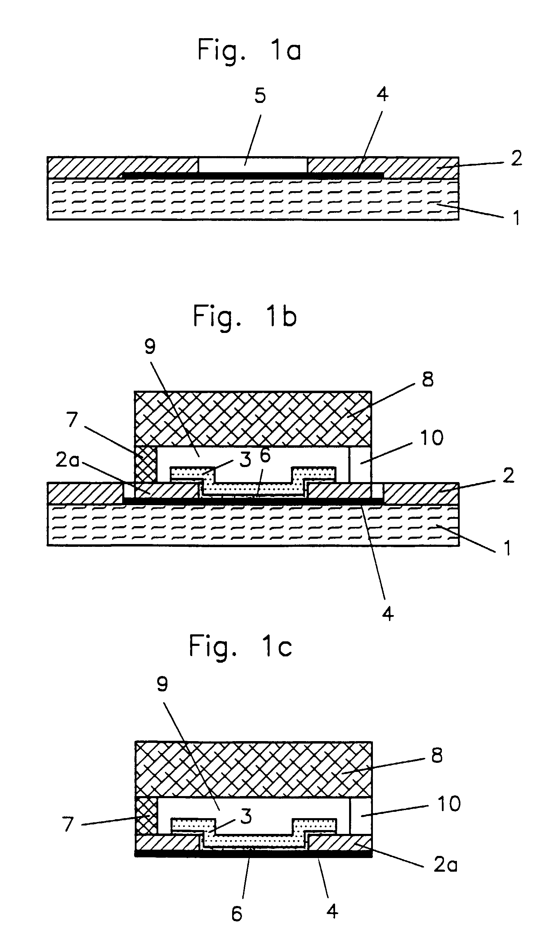

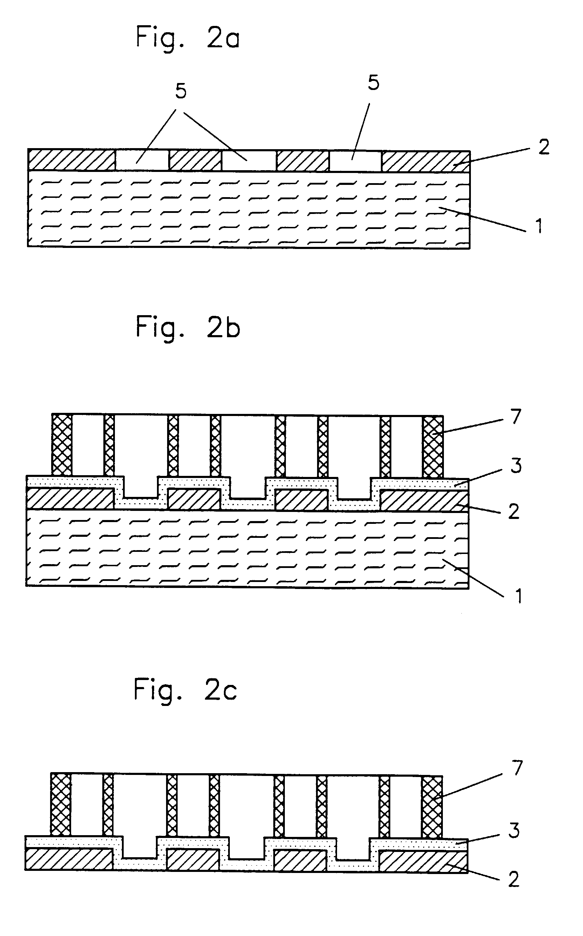

Die Erfindung wird im folgenden anhand der Figuren 1 und 2 und zweier Ausführungsbeispiele näher erläutert. Dabei zeigen die Figuren schematisch die einzelnen Verfahrensschritte.

Das erste Anwendungsbeispiel beschreibt die Herstellung einer Membran mit lokal unterschiedlicher Dehnbarkeit mit Hilfe zweier Trennschichten:

Wie in der eingangs genannten Veröffentlichung beschrieben, wurde eine runde, ca. 0,5 mm dicke Siliziumscheiben 1 mit einem Durchmesser von 100 mm mit einer ca. 100 nm dünnen Trennschicht 4 aus Kohlenstoff durch Magnetronzerstäubung beschichtet (vgl. **Fig. 1a**). Am Rand der Siliziumscheibe wurde dabei ein ca. 3 mm breiter Streifen vom Kohlenstoff frei belassen. Siliziumscheibe 1 und Kohlenstoffschicht 4 wurden dann durch Magnetronzerstäubung mit einer 2,7 µm dünnen Titanschicht 2 überschichtet. Nach dem Aufbringen war in der Titanschicht 2 zunächst eine innere mechanische Druckspannung von ca. 600 N/mm² vorhanden. Durch eine halbstündige Aufwärmung der Titanschicht 2 auf ca. 450° C wurde der Spannungszustand der Schicht 2 in eine Zugspannung von ca. 200 N/mm² gewandelt. Der Elastizitätsmodul der Titanschicht betrug ca. 130000 N/mm². Die Oberfläche der Titanschicht wurde durch eine Behandlung in Wasserstoffsuperoxid oxidiert und chemisch aufgerauht.

Mit bekannten Methoden der Fotolithographie und durch naßchemisches Ätzen mit einer Lösung, die 5 % Flußsäure und eine Oberflächen benetzende Flüssigkeit (Tensid) enthielt, wurden kreisrunde Flächen 5 mit Durchmessern zwischen 0,1 und 5 mm der Titanschicht aufgelöst. Die Probe wurde dann durch Kathodenzerstäubung in einem Parallelplattenreaktor mit einer ca. 50 nm dünnen Schicht aus Gold 6 überschichtet, die eine sehr geringe Haftung zur Siliziumscheibe aufwies (vgl. **Fig. 1b**). Die Haftung der Goldschicht 6 zur oxidierten Titanoberfläche war dagegen sehr viel größer.

Die Probe wurde mit einer 1,5 µm dünnen Schicht eines handelsüblichen, fotolithographisch strukturierbaren Polyimides 3 beschichtet. In der Polyimidschicht 3 bildete sich eine innere Zugspannung von ca. 50 N/mm² aus. Der Elastizitätsmodul der Polyimidschicht betrug nur ca. 3500 N/mm². Dadurch war die Polyimidschicht wesentlich dehnbarer als die Titanschicht.

Die Polyimidschicht wurde mit bekannten Methoden der Fotolithographie strukturiert, so daß die kreisrunden Durchbrüche 5 in der Titanschicht 2 über ihren Rand hinaus mit einer Polyimidschicht 3 bedeckt blieben (vgl. **Fig. 1b**). Durch die Goldschicht 6 war die Haftung der Polyimidschicht 3 zur Siliziumscheibe 1 stark reduziert. Mit einem Argonplasma wurde die dünne Goldschicht 6 außerhalb der Polyimidscheibe entfernt, so daß beim folgenden Aufbau von Mikrostrukturen um die Polyimidschicht 3 herum keine durch das Gold 6 verminderte Haftung der Mikrostrukturen zum Titan zu befürchten war.

Mit dem in "E. W. Becker et al, Microcircuit Engineering 4 (1986), Seiten 35 bis 56" beschriebenen LIGA-Verfahren (Röntgentiefenlithographie und galvanische Abformung) wurden um die Polyimidschichten 3 herum Mikrostrukturen 7 aus Kupfer aufgebaut und mit einer Abdeckplatte 8 verschlossen, so daß Pumpenkammern 9 mit Zuleitungen 10 entstanden (**Fig. 1b**). Die mit dem LIGA-Verfahren verbundene galvanische Abscheidung des Kupfers auf der Titanschicht 2 war möglich, weil zuvor das elektrisch isolierende Polyimid strukturiert worden war. Auf diese Weise wurde ein direkter Zugang des Galvanikelektrolyten zur leitfähigen Titanoberfläche möglich.

Die Titanschicht 2 wurde um die Kupferstrukturen 7 herum durchtrennt und die Abdeckplatte 8 und die Strukturen 7 zusammen mit der Titanschicht 2a und der an ihr über die Goldschicht 6 haftende Polyimidschicht 3 von der Siliziumscheibe 1 getrennt (**Fig. 1c**). Dabei wurde eine rein mechanische Trennung ohne das Auflösen einer Schicht durch die Trennschichten 4 und 6 möglich. Versuche zeigten, daß bei Durchbrüchen 5 in der Titanschicht, die kleiner sind als ca. 10 µm, auf die Goldschicht 6 verzichtet werden kann. Bei größeren Durchbrüchen 5 in der Titanschicht wird die Polyimidschicht 3 bei der mechanischen Trennung von der Siliziumscheibe 1 aufgrund ihrer geringeren inneren Zugspannung und ihres kleineren Elastizitätsmoduls leicht beschädigt. Da eine Goldschicht zwischen der Titanschicht 2a und der Siliziumscheibe 1 möglicherweise nicht zu einer so guten Ablösung wie die Goldschicht zwischen der Polyimidschicht 3 und der Siliziumscheibe 1 führen könnte, ist es nicht in jedem Falle möglich, die Trennschicht 4 durch Gold zu ersetzen und auf die Trennschicht 6 zu verzichten. Darüber hinaus besteht die Gefahr, daß die Trennschicht 4 bei der Ätzung des Durchbruchs 5 in die Titanschicht 2 beschädigt wird, so daß eine beschädigungsfreie Trennung von Polyimidschicht 3 und Siliziumscheibe 1 nur über das Aufbringen der Goldschicht 6 sichergestellt werden kann.

Durch eine periodische Bewegung der Polyimidmembran 3 mittels eines Antriebs ist es jetzt möglich, die Pumpenkammer mit einem Medium zu füllen und zu leeren. Die große Dehnbarkeit der Polyimidmembran 3 reduziert dabei den Energieaufwand, der für die Auslenkung der Membran aufgewandt werden muß, während die Zuleitungen 10 durch eine nur wenig dehnbare Titanmembran fest verschlossen sind.

In Fig. 1 ist der Übersichtlichkeit halber nur die Herstellung einer Membran dargestellt, die an einer Stelle 5 lokal dehnbarer gemacht worden ist. Es ist aber auch möglich, viele Stellen auf einer Membran dehnbarer zu gestalten und so viele Pumpenkammern mit Zuleitungen kostensparend gleichzeitig herzustellen.

Wenn die Flächen 5 einen größeren Durchmesser aufweisen, wurde oft eine Beschädigung der Kohlenstoffschicht 4 im Bereich der aufgelösten Titanschicht festgestellt. Diese Beschädigungen der Kohlenstoffschicht verhinderten eine beschädigungsfreie Herstellung darauf aufgebrachter Schichten. Deshalb war es bei großen Flächen 5 vorteilhaft die Kohlenstoffschicht 4 im Bereich dieser Flächen mit einem Sauerstoffplasma zu entfernen.

Im zweiten Anwendungsbeispiel wird die Herstellung einer Sensorstruktur ohne die Hilfe von Trennschichten beschrieben, die aus einer über einer Mikrostruktur gespannten Membran mit lokal unterschiedlichen Schwingungseigenschaften besteht.

Auf einer 4 mm dicken Titanplatte 1 wird eine ca. 2 µm dünne Wolframschicht 2 durch Kathodenzerstäubung aufgebracht. Durch die geeignete Wahl der Herstellungsbedingungen wird in der Wolframschicht eine Zugspannung von ca. 100 N/mm² eingestellt. Mit bekannten Methoden der Fotolithographie und durch naßchemisches Ätzen werden in die Wolframschicht sechseckige Durchbrüche 5 eingebracht (vgl. **Fig. 2a**). Die Probe wird durch Magnetronzerstäubung mit einer 1 µm dünnen Schicht 3 aus Kupfer beschichtet. Die Kupferschicht 3 wird ebenfalls mit einer inneren Zugspannung von 100 N/mm² hergestellt. Am Rande der Durchbrüche 5 in der Wolframschicht wird eine mit dem LIGA-Verfahren hergestellte wabenförmige Mikrostruktur aus Kupfer so gefertigt, daß abwechselnd Waben entstehen, in denen sich Schichten aus Wolfram und Kupfer bzw. nur aus Kupfer befinden (vgl. **Fig. 2b**). Der Herstellungsprozeß der Sensorstrukturen wird damit abgeschlossen, daß die Titanplatte in einer wäßrigen Lösung, die Flußsäure enthält, aufgelöst wird. Auf diese Weise entsteht eine freistehende Wabenstruktur, bei der die Hälfte der Waben mit Mikromembranen aus Kupfer und die andere Hälfte der Waben mit Bimetallmembranen aus Kupfer und Wolfram verschlossen ist (**Fig. 2c**).

Mit Ultraschall können die Mikromembranen zu Schwingungen mit Frequenzen von einigen MHz angeregt werden. Durch die unterschiedlichen Dichten und Dicken der Mikromembranen weisen diese unterschiedliche Resonanzfrequenzen auf, die durch Analyse des durch die Membranen hindurchgetretenen Ultraschallsignales ermittelt werden können. Die Lage der Resonanzfrequenz der Bimetallmembranen ist temperaturabhängig, während sich für die nur aus Kupfer gefertigten Mikromembranen fast keine Abhängigkeit von der Temperatur ergibt. Dagegen ist die Lage der Resonanzfrequenz für beide Mikromembrantypen von der Dehnung der Mikrostruktur durch äußere Kräfte bestimmt. Durch eine Eichung und die gleichzeitige Messung der Resonanzfrequenzen beider Mikromembrantypen kann also auf die Dehnung und die Temperatur der Sensorstruktur geschlossen werden. Wenn die hier beschriebene Sensorstruktur irgendwo im menschlichen Körper plaziert wird, ist es also möglich, die Dehnung und die Temperatur im Körperinneren durch eine Ultraschallmessung von der Hautoberfläche aus zu bestimmen.

In Fig. 2 ist der Übersichtlichkeit halber nur eine aus mehreren Waben bestehende Sensorstruktur dargestellt. Es ist aber auch möglich mehrere Sensorstrukturen gleichzeitig nebeneinander herzustellen und so Produktionskosten zu sparen.

## Patentansprüche

1. Verfahren zur Herstellung mindestens einer durch einen Rahmen (7) aufgespannten Membran (2a, 3), bei dem
a) auf einem Substrat (1) mindestens eine Membranschicht (2a, 3) in der Weise aufgetragen wird, daß sie sich vom Substrat (1) trennen läßt,
b) auf der mindestens einen Membranschicht (2a, 3) der Rahmen (7) aufgebaut wird,
c) die mindestens eine Membranschicht (2a, 3) mit dem Rahmen (7) vom Substrat (1) getrennt wird,
dadurch gekennzeichnet, daß
d) auf dem Substrat (1) eine erste Membranschicht (2a) aufgetragen wird,
e) die erste Membranschicht (2a) mit mindestens einem Durchbruch (5) versehen wird,
f) der Durchbruch (5) in der ersten Membranschicht (2a) mit einer zweiten Membranschicht (3) überdeckt wird.

2. Verfahren nach Anspruch 1, dadurch gekennzeichnet, daß das Substrat (1) vor dem Auftragen der ersten Membranschicht mit mindestens einer Trennschicht versehen wird.

3. Verfahren nach Anspruch 2, dadurch gekennzeichnet, daß auf der Trennschicht (4) im Bereich des Durchbruchs (5) eine weitere Trennschicht (6) aufgebracht wird.

4. Verfahren nach Anspruch 2, dadurch gekennzeichnet, daß die Trennschicht (4) im Bereich des Durchbruchs (5) entfernt und durch eine weitere, aus einem anderen Material bestehende Trennschicht (6) ersetzt wird.

5. Verfahren nach Anspruch 2, 3 oder 4, dadurch gekennzeichnet, daß
die Trennschichten (4, 6) aus Kohlenstoff oder Gold bestehen.

6. Verfahren nach Anspruch 1 oder 2, dadurch gekennzeichnet, daß die erste Membranschicht (2a) aus einem Metall und die zweite Membranschicht (3) aus einem Kunststoff besteht.

7. Verfahren nach Anspruch 6, dadurch gekennzeichnet, daß der Kunststoff aus einem photolithographisch strukturierbaren Kunststoff besteht.

8. Verfahren nach Anspruch 1 oder 2, dadurch gekennzeichnet, daß die erste Membranschicht (2a) und die zweite Membranschicht (3) aus verschiedenen Metallen bestehen.

9. Verfahren nach einem der Ansprüche 1 bis 8, dadurch gekennzeichnet, daß auf dem Rahmen (7) eine Deckplatte (8) angebracht wird.

## Claims

1. Method of producing at least one diaphragm (2a, 3), which is stretched by a frame (7), wherein
a) at least one diaphragm layer (2a, 3) is applied to a substrate (1) in such a manner that it can be separated from the substrate (1),
b) the frame (7) is constructed on at least the one diaphragm layer (2a, 3), and
c) at least the one diaphragm layer (2a, 3), with the frame (7), is separated from the substrate (1),
characterised in that
d) a first diaphragm layer (2a) is applied to the substrate (1),
e) the first diaphragm layer (2a) is provided with at least one opening (5), and
f) the opening (5) in the first diaphragm layer (2a) is covered with a second diaphragm layer (3).

2. Method according to claim 1, characterised in that the substrate (1) is provided with at least one parting layer prior to the application of the first diaphragm layer.

3. Method according to claim 2, characterised in that an additional parting layer (6) is applied to the parting layer (4) in the region of the opening (5).

4. Method according to claim 2, characterised in that the parting layer (4) is removed in the region of the opening (5) and replaced by an additional parting layer (6), which is formed from a different material.

5. Method according to claim 2, 3 or 4, characterised in that the parting layers (4, 6) are formed from carbon or gold.

6. Method according to claim 1 or 2, characterised in that the first diaphragm layer (2a) is formed from a metal, and the second diaphragm layer (3) is formed from a plastics material.

7. Method according to claim 6, characterised in that the plastics material is formed from a photolithographically structurable plastics material.

8. Method according to claim 1 or 2, characterised in that the first diaphragm layer (2a) and the second diaphragm layer (3) are formed from different metals.

9. Method according to one of claims 1 to 8, characterised in that a cover plate (8) is attached to the frame (7).

## Revendications

1. Procédé de fabrication d'au moins une membrane (2a, 3) tendue par un cadre (7), dans lequel :
a) on applique sur un substrat (1) au moins une couche de membrane (2a, 3) d'une manière telle qu'on peut la séparer du substrat (1),
b) on monte le cadre (7) sur au moins une couche de membrane (2a, 3),
c) on sépare du substrat (1) l'une au moins des couches de membrane (2a, 3) avec le cadre (7),
caractérisé en ce que
d) sur le substrat (1) on applique une première couche de membrane (2a),
e) la première couche de membrane (2a) est pourvue d'au moins un ajour (5),
f) l'ajour (5) dans la première couche de membrane (2a) est recouvert par une seconde couche de membrane (3).

2. Procédé selon la revendication 1,
caractérisé en ce que
le substrat (1) est pourvu, avant l'application de la première couche de membrane par au moins une couche de séparation.

3. Procédé selon la revendication 2,
caractérisé en ce que sur la couche de séparation (4) dans la zone de l'ajour(5) on applique une autre couche de séparation (6).

4. Procédé selon la revendication 2,
caractérisé en ce qu'
on enlève la couche de séparation (4) dans la zone de l'ajour(5) et on la remplace par une autre couche de séparation (6), réalisée en une autre matière.

5. Procédé selon la revendication 2, 3 ou 4,
caractérisé en ce que
les couches de séparation (4,6) sont réalisées en carbone ou en or.

6. Procédé selon la revendication 1 ou 2,
caractérisé en ce que
la première couche de membrane (2a) est réalisée en un métal et la deuxième couche de membrane est réalisée en une matière plastique.

7. Procédé selon la revendication 6,
caractérisé en ce que
la matière plastique consiste en une matière plastique qui peut être structurée de façon photolithographique.

8. Procédé selon la revendication 1 ou 2,
caractérisé en ce que
la première couche de membrane (2a) et la seconde couche de membrane (3) sont réalisées en des métaux différents.

9. Procédé selon l'une des revendications 1 à 8,
caractérisé en ce qu'
on met sur le cadre (7) une plaque de recouvrement (8).
